# EUROPEAN PATENT APPLICATION

(11) **EP 4 766 063 A1**
(43) Date of publication of application: **24.06.2026**
(21) Application number: 25184719.0
(22) Date of filing: 24.06.2025
(51) Int. Cl.: H10B 12/00, H10D 30/67, G11C 11/405

(54) **GAIN CELL EDRAM WITH EXTENDED CAPACITANCE**

(30) Priority: 20.12.2024 US 202418990709
(71) Applicant: GlobalFoundries U.S. Inc., Malta, NY 12020 (US)
(72) Inventor: Pritchard, David, Malta, NY 12020 (US); Lanza, Brenda, Austin, TX 78735 (US); Galla, Kiran Kumar, 560045 Bengaluru (IN); Feuillette, Romain, Essex Junction, VT 05452 (US); Lazar, Heather, Malta, NY 12020 (US); Jain, Navneet, Santa Clara, CA 95054 (US)
(74) Representative: Grünecker Patent- und Rechtsanwälte PartG mbB

(57) **Abstract**

A gain cell memory device includes a semiconductor device layer of a silicon on insulator (SOI) substrate comprising an active region, a storage transistor over the active region of the semiconductor device layer, an isolation structure between a gate electrode of the storage transistor and a source/drain region adjacent to the storage transistor, the isolation structure extending through the active region such that a first portion of the active region is isolated from a second portion of the active region, and a capacitor coupled to the storage transistor. A bottom plate of the capacitor comprises the first portion of the active region, a gate dielectric layer of the storage transistor is an insulator of the capacitor, and a top plate of the capacitor comprises the gate electrode of the storage transistor and a metal structure over the gate electrode.

## Description

### BACKGROUND

Gain-cell embedded DRAM (eDRAM) is a compact, low-power and CMOS-compatible alternative to conventional SRAM. Gain cell eDRAM achieves high memory density as it typically uses storage cells that can be implemented with as few as two transistors (2T) and that can be fabricated without additional process steps. In a gain cell, the amount of electric charge can be amplified by a read transistor and the electric charge can be supplied to a bitline. Gain cell eDRAM uses gate capacitors from dummy field effect transistors (FETs) which can be formed adjacent to other active structures on a wafer.

However, gain cell eDRAM suffers from leakages that limit retention times of the associated memory cells. This requires regular refresh cycles to retain data, which consume power and generate heat. eDRAM can benefit from improvements in capacitance, which can increase retention time and reduce heat and power consumption.

### SUMMARY

Embodiments of the present application relate to a gain cell memory device, an array of embedded dynamic random access memory (eDRAM) devices, and a method for forming a gain cell memory device.

In an embodiment, a gain cell memory device includes an active region of a semiconductor device layer of a silicon on insulator (SOI) substrate, a storage transistor over the active region, an isolation structure between a gate electrode of the storage transistor and a source/drain region adjacent to the storage transistor, the isolation structure extending through the active region such that a first portion of the active region under the storage transistor is isolated from a second portion of the active region, and a capacitor coupled to the storage transistor. A bottom plate of the capacitor comprises the first portion of the active region, a gate dielectric layer of the storage transistor is an insulator of the capacitor, and a top plate of the capacitor comprises the gate electrode of the storage transistor and a metal structure over the gate electrode.

In an embodiment, each gain cell eDRAM device of an array of gain cell eDRAM devices includes an active region of a semiconductor device layer of a silicon on insulator (SOI) substrate, a storage transistor over the active region, an isolation structure between a gate electrode of the storage transistor and a source/drain region adjacent to the storage transistor, the isolation structure extending through the active region such that a first portion of the active region under the storage transistor is isolated from a second portion of the active region, and a capacitor coupled to the storage transistor. A bottom plate of the capacitor comprises the first portion of the active region, a gate dielectric layer of the storage transistor is an insulator of the capacitor, and a top plate of the capacitor comprises the gate electrode of the storage transistor and a metal structure over the gate electrode.

In an embodiment, a method for forming a gain cell memory device includes forming an active region in a semiconductor device layer of a silicon on insulator (SOI) substrate, forming a storage transistor over the semiconductor device layer, the storage transistor comprising a gate dielectric and a gate electrode, forming an isolation structure between the gate electrode of the storage transistor and a source/drain region adjacent to the storage transistor, the isolation structure extending through the active region such that a first portion of the active region under the storage transistor is isolated from a second portion of the active region, and forming a capacitor coupled to the storage transistor, wherein a bottom plate of the capacitor comprises the first portion of the active region, the gate dielectric layer of the storage transistor is an insulator of the capacitor, and a top plate of the capacitor comprises the gate electrode of the storage transistor and a metal structure over the gate electrode.

### BRIEF DESCRIPTION OF THE DRAWINGS

FIG. 1 illustrates a schematic diagram of a portion of a three terminal gain cell memory device according to an embodiment of the present disclosure.
FIG. 2 illustrates a cross-sectional view taken along line X-X' of FIG. 1.
FIG. 3 illustrates a capacitor of the three terminal gain cell memory device of FIG. 1.
FIG. 4 is a circuit diagram of the three transistor gain cell of FIG. 1.
FIGS. 5A to 5F illustrate process steps for a method of forming the gain cell of FIG. 1.
FIG. 6 illustrates a schematic diagram of a portion of a two transistor gain cell memory device according to an embodiment of the present disclosure.
FIG. 7 illustrates a cross-sectional view taken along line X-X' of FIG. 6.
FIG. 8 is a circuit diagram of the two transistor gain cell of FIG. 6.
FIG. 9 illustrates a capacitor of the two terminal gain cell memory device of FIG. 6.

### DETAILED DESCRIPTION

A detailed description of embodiments is provided below along with accompanying figures. The scope of this disclosure is limited by the claims and encompasses numerous alternatives, modifications and equivalents. Although steps of various processes are presented in a given order, embodiments are not necessarily limited to being performed in the listed order. In some embodiments, certain operations may be performed simultaneously, in an order other than the described order, or not performed at all.

Numerous specific details are set forth in the following description. These details are provided to promote a thorough understanding of the scope of this disclosure by way of specific examples, and embodiments may be practiced according to the claims without some of these specific details. Accordingly, the specific embodiments of this disclosure are illustrative, and are not intended to be exclusive or limiting. For the purpose of clarity, technical material that is known in the technical fields related to this disclosure has not been described in detail so that the disclosure is not unnecessarily obscured. The figures are not drawn to scale, and features are enlarged or diminished for visual clarity.

Gain cells are similar to conventional DRAM, but use a second transistor instead of a capacitor to store data. That data is stored in the form of charge on the second transistor's gate, which is a capacitive structure that controls the flow of current through the transistor. Capacitors in conventional DRAM leak their charge over time, and reading out the data destroys it. In a gain cell, reading out the signal is nondestructive.

Embodiments of the present disclosure extend the amount of capacitance that would otherwise be available in a storage transistor by providing an isolating structure that interrupts an active area below a storage transistor so that an isolated portion of the active area can act as a bottom plate of a capacitor.

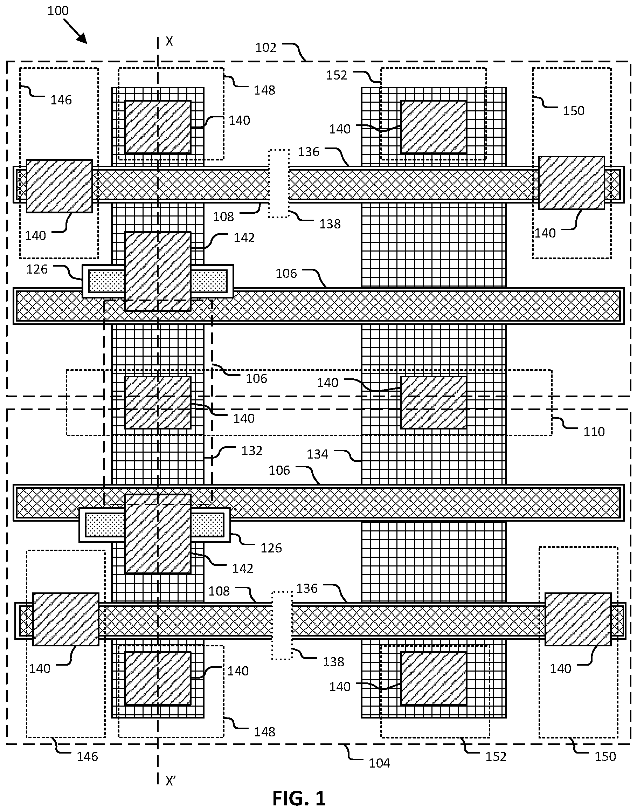

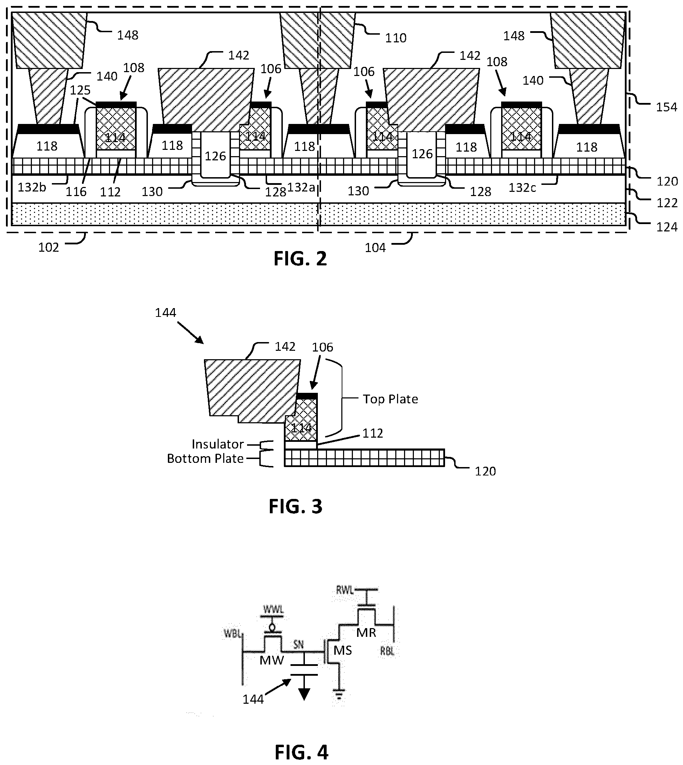

FIG. 1 illustrates a schematic diagram of a portion of a three terminal (3T) gain cell memory device 100 according to an embodiment of the present disclosure, and FIG. 2 illustrates a cross-sectional view taken along line X-X' of FIG. 1. The embodiment in these figures is a three transistor (3T) device with a mirrored array. The memory device 100 comprises a first gain cell 102 and a second gain cell 104 which are commonly coupled to the same ground line 110.

Each gain cell comprises a storage transistor 106 and a write transistor 108. The storage transistors 106 are not operated as transistor devices, and instead serve as storage nodes which capacitively store a charge. The storage transistors 106 are floating transistors, e.g. the gate electrodes 114 of the storage transistors 106 are not coupled to a voltage line through a gate contact.

The transistors comprise a gate dielectric 112 and a gate electrode 114 that is separated from the device layer 120 by the gate dielectric 112. The gate dielectric 112 may comprise one or more high-K dielectric material such as hafnium oxide. The gate electrode 114 may be composed of a doped polysilicon material. Non-conductive sidewall spacers 116 may be disposed over the sidewalls of the gate electrode 114.

Source/drain regions 118 are laterally arranged on opposite sides of the gate electrodes 114. As used herein, the term "source/drain region" refers to a doped region of semiconductor material that can function as either a source or a drain of a field-effect transistor. In an embodiment, the semiconductor material of the source/drain regions 118 may be silicon and may contain ap-type dopant (e.g., boron, gallium, and/or zinc) that provides p-type conductivity or an n-type dopant (e.g., phosphorus and/or arsenic) that provides n-type conductivity. The source/drain regions 118 in the embodiment of FIG. 2 are raised source/drain regions. Each of the source/drain regions 118 and gate electrodes 114 are capped with a silicide layer 125.

The transistors 108 and 106 may be fabricated using a semiconductor-on-insulator (SOI) wafer by complementary metal oxide semiconductor (CMOS) processes during front-end-of-line (FEOL) processing. The SOI wafer includes a device layer 120, a buried insulator layer in the form of a buried oxide (BOX) layer 122, and a substrate 124. The device layer 120 is separated from the substrate 124 by the intervening BOX layer 122 and is considerably thinner than the substrate 124.

In an embodiment, the SOI wafer may be an extremely thin semiconductor-on-insulator (ETSOI) wafer with a thin device layer 120 and a thin BOX layer 122, and may be used to fabricate transistors as fully-depleted SOI (FDSOI) devices. The device layer 120 may comprise a semiconductor material such as silicon germanium. In an embodiment, the device layer 120 of the ETSOI wafer may have a thickness that ranges from about 3 nanometers (nm) to about 100 nm. In an embodiment, the device layer 120 of the ETSOI wafer may have a thickness in an ultra-thin regime (e.g., about 3 nm to about 10 nm) suitable to manufacture FDSOI devices. In an embodiment, the BOX layer 122 may have a thickness in a range from about 5 nm to about 50 nm that is suitable to manufacture FDSOI devices.

Isolation structures 126 are located between source/drain regions 118 of each storage transistor 106 and are on a write transistor side of the storage transistors 106. The isolation structures 126 extend vertically through device layer 120 to isolate a portion of active region 132 of device layer 120 that extends below two adjacent storage transistors 106 (in the case of a mirrored array) from portions of device layer 120 that run below the write transistors 108, e.g. channel regions of the WWL transistors 108. Accordingly, the isolation structures 126 extend through the entire device layer 120 and a portion of the isolation structures 126 may extend into BOX layer 122. The isolation structures 126 include an insulation material 128, which may be an oxide of silicon, and a liner 130, which may be a nitride material such as silicon nitride or silicon oxynitride.

Referring to FIG. 1, the gain cell memory device 100 includes a first active region 132 and a second active region 134 which are doped regions of device layer 120. The first active region 132 may be a P-doped material and the second active region 134 may be an N-doped material (or vice-versa). The first active region 132 is associated with a write portion of the gain cells 102 and 104, and the second active region 134 is associated with a read portion of the gain cells. Read transistors 136 are separated from write transistors 108 by a cut 138 in the transistor body such that write transistors 108 may be NMOS transistors and read transistors 136 may be PMOS transistors (or vice-versa). The isolation structures 126 extend across the entire width of first active region 132. The transistors, raised source and drain regions, and active regions may be formed by front end of line (FEOL) processes as known in the art.

Interconnect structures including contacts 140 are coupled to source-drain regions 118 of active transistors and gate electrodes of read and write transistors and may be formed by middle of line (MOL) processes. The contacts 140 may comprise a metal material such as tungsten. In addition, conductive plates 142 may be formed over isolation structures 126 using a MOL process. Because selective etch steps which erode source/drain regions 118 may be used to form conductive plates 142, the contacts 140 may be formed separately from the conductive plates 142. The conductive plates 142 may comprise a conductive metal material such as tungsten, or a different conductive material or combination of materials.

The conductive plates 142 extend over the isolation structure 126 and a portion of the silicide in a source/drain region 118 of the write transistors 108, and are electrically coupled to the gate electrodes 114 of the storage transistors 106. As seen in FIG. 3, in combination with the gate electrode 114 of the storage transistors 106, the conductive plates act as a top cap of a capacitor 144 according to an embodiment of the present disclosure. The gate dielectric 112 of the storage transistors 106 acts as an insulator of the capacitor 144, and the isolated portion of the first active region 132 (of device layer 120) acts as the bottom plate of the capacitor 144.

In the embodiment of FIG. 2, the isolation structures 126 separate the active region 132 into a first portion 132a, a second portion 132b and a third portion 132c. The first portion 132a of the active region may act as a bottom plate of a first capacitor 144 comprising the gate electrode 114 and metal plate 142 of the first gain cell 102, as well as that of a second capacitor 144 comprising the gate electrode 114 and metal plate 142 of the second gain cell 104. Accordingly, in a mirrored array, two isolation structures 126 may provide a bottom plate that is shared by capacitors of each gain cell of the mirrored array.

Back-end-of-line (BEOL) processing is performed to form subsequent metal layers. The metal layers may include metal lines that are write word lines (WWL) 146, write bit lines (WBL) 148, read bit lines (RBL) 150, read word lines (RWL) 152, ground lines 110, and other interconnect structures. While FIG. 2 shows WWL 146 on metal layer M1, the metal lines may be located on various metal layers in different embodiments. Each WWL 146 may be coupled to a gate electrode 114 of a write transistor 108 and each RWL 150 may be coupled to a gate electrode 114 of a read transistor 136, while WBLs 148 and RBLs 152 are coupled to source/drain regions 118 of the corresponding write/read transistors.

FIG. 4 is a circuit diagram of a three transistor gain cell 102 or 104 according to an embodiment of the present disclosure. The capacitor 144 extends the capacitance of storage node SN, and is coupled between a write transistor MW (e.g. write transistor 108) and a sense transistor MS.

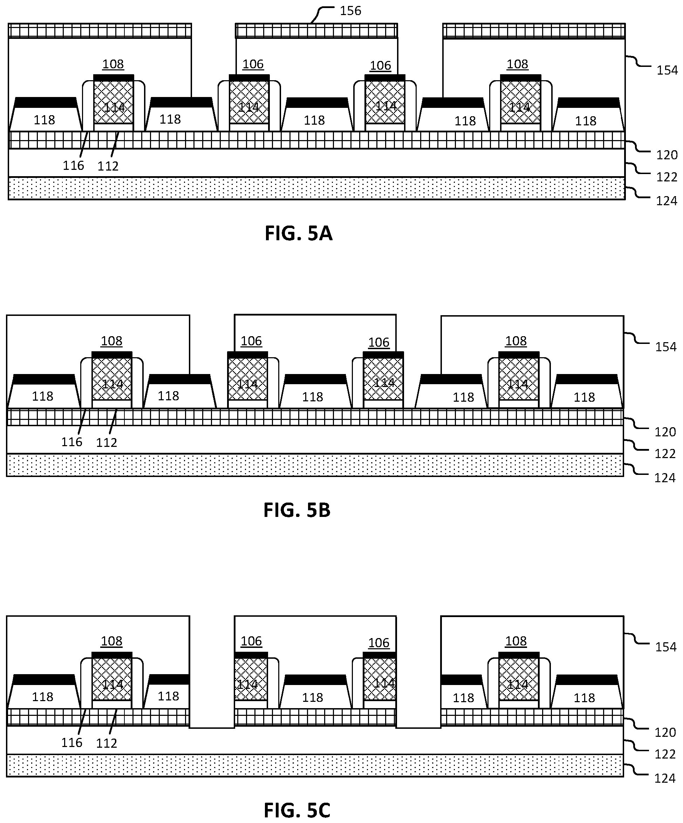

FIGS. 5A to 5F illustrate steps in an embodiment of a process for forming the gain cell memory device 100 of FIG. 2. As seen in FIG. 5A, an interlayer dielectric layer (ILD) 154 is formed over transistors 106 and 108 which are formed using FEOL processes. The ILD material may be a silicon oxide such as a tetraethyl orthosilicate (TEOS), for example. A hard mask pattern 156 is deposited over the ILD layer 154, and a portion of the ILD layer is etched using the hard mask 156 as an etch mask to expose a portion of the storage transistor 106 and an adjacent source/drain region 118 between the storage transistor 106 and the associated write transistor 108.

Next, as seen in FIG. 5B, the hard mask 156 is removed and a selective spacer etch operation is performed to remove a portion of a sidewall spacer 116 from one side of the storage transistor 106. Referring to FIG. 5C, a selective etch, e.g. a selective silicon etch, is performed using the same opening to extend the opening through the device layer 120, and possibly into the underlying BOX layer 122. This selective etch may remove a portion of one side of the gate electrode 114 of storage transistor 106 as well as a side portion of the adjacent source/drain region 118, and may be controlled so that a majority of the thickness of BOX layer 122 remains intact.

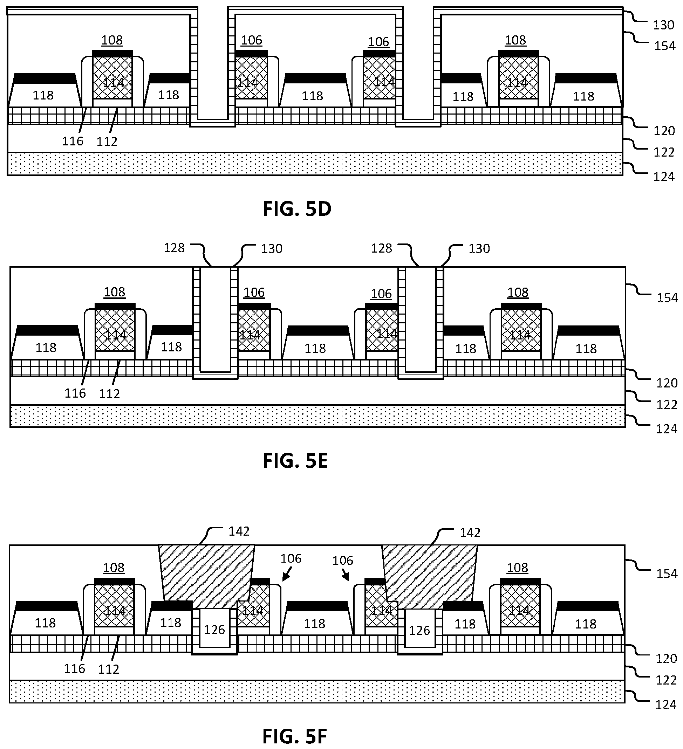

Referring to FIG. 5D, a liner material 130 (e.g. silicon nitride or silicon oxynitride) is deposited over the exposed surface covering sidewalls and the base of the openings. As seen in FIG. 5E, insulation material 128 is deposited to fill the openings, and a planarization process such as chemical mechanical polishing (CMP) stopping at the ILD layer 154 may be performed to remove insulation material 128 and liner material 130 from the top surface.

Conductive plates 142 are formed as seen in FIG. 5F using a damascene process. The etch process may be a dual damascene process in which a first etch mask is formed and used to etch the insulation material 128 and the liner material 130, a second etch mask is used to etch the ILD layer 154, a metal material is deposited in the resulting openings, and the metal material is planarized by a process such as CMP to form the conductive plates 142. In some embodiments (not shown), at least some of the contacts 140 may be formed by etching contact holes in the second etch step of the dual damascene process. Of course, other embodiments are possible, including a single damascene process and forming the contacts 140 separately from forming the conductive plates 142.

In the resulting structure, the source/drain regions 118 between the write transistors 108 and storage transistors 106 are shorted to the conductive plates 142, and a portion of the device layer 120 of the first active region 132a, which serves as the bottom plate of capacitor 144, extends between the two isolation structures 126.

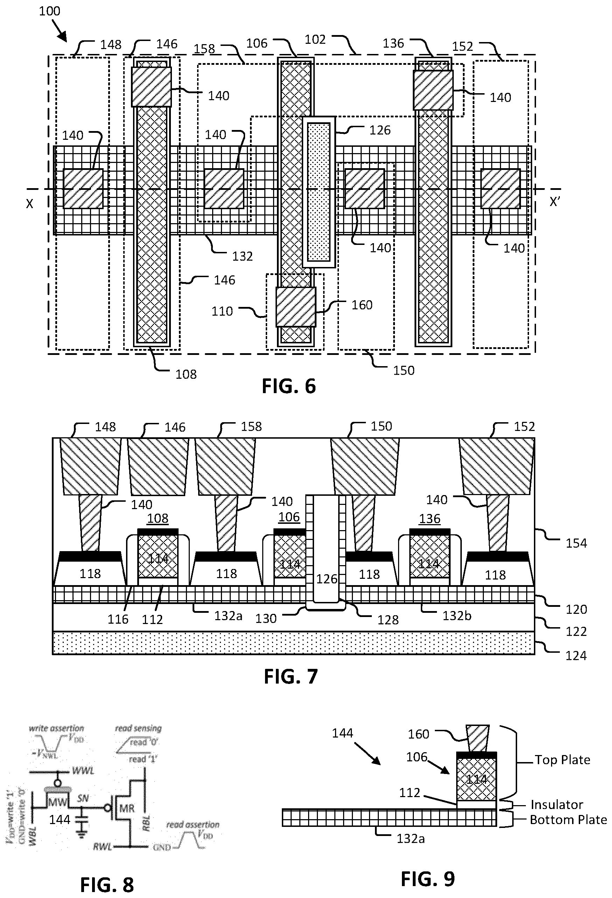

FIG. 6 illustrates a schematic diagram of a memory device 100 that is a two terminal (2T) gain cell according to an embodiment of the present disclosure, and FIG. 7 is a cross-sectional view of the 2T gain cell taken along line X-X' of FIG. 6.

The 2T gain cell of FIG. 6 includes an active region 132 that extends between a write transistor 108 and read transistor 136 across a storage transistor 106 between the read and write transistors, and comprises an isolation structure 126 that separates a first portion 132a of the active region 132 from a second portion 132b. The isolation structure 126 lies against a side of the gate electrode 114 of storage transistor 106 between the storage transistor 106 and a source/drain region 118 of read transistor 136, and extends upwards to the base of metal layer M1. Accordingly, the isolation structure 126 of FIG. 7 may be formed in a similar fashion to the method described with respect to FIGS. 5A to 5E without performing the damascene process to form metal plate 142 of FIG. 5F.

Although FIG. 7 shows WWL 146, WBL 148, RWL 150 and RBL 152 on metal layer M1, in some embodiments, one or more of the bit and word lines and/or various connection structures of the memory device 100 may be located on metal layer M2 or other metal layers.

As seen in FIG. 6 and referring to the circuit diagram of FIG. 8, a storage node (SN) connection between the gate electrode 114 of read transistor 136 and a source/drain region 118 of write transistor 108 may be provided by an L-shaped metal structure 158. The metal structure 158 may have an L-shape to avoid interfering with metal lines of the device 100, e.g. RWL 150. In addition, the gate electrode 114 of storage transistor 106 is coupled to ground line 110 by ground contact 160.

A capacitor structure 144 of the 2T gain cell of FIG. 6 is illustrated in FIG. 9. A bottom plate of the capacitor structure 144 comprises a first portion 132a of active region 132. The insulator of the capacitor structure 144 is the dielectric layer 112, and the top plate comprises the gate electrode 114 of storage transistor 106 as well as the ground contact 160 coupled to the gate electrode. The view of FIG. 9 is not a cross-sectional view of FIG. 6 since the ground contact 160 is laterally offset from the active region 132 in that embodiment.

A capacitor 144 according to the embodiments described above may comprise a first portion 132a of an active region 132 under a storage transistor 106, the gate dielectric layer 112 and gate electrode 114 of the storage transistor, and a metal structure coupled to the gate electrode 114. Examples of the metal structure include a metal plate 142 and a ground contact 160.

The capacitor 144 extends the capacitance of a memory device 100, which increases the data retention time of the memory device. In various embodiments, the dimensions and materials of the capacitors 144 may be adapted to increase the capacitance of a capacitor 144 to provide retention times that can be substantially longer than a device lacking a capacitor.

A memory device 100 according to the present disclosure may be realized as embedded DRAM (eDRAM). The eDRAM may be integrated with a circuit such as an application-specific integrated circuit (ASIC) or microprocessor with extended capacitance.

Aspects of the present disclosure have been described in conjunction with the specific embodiments thereof that are proposed as examples. Numerous alternatives, modifications, and variations to the embodiments as set forth herein may be made without departing from the scope of the claims set forth below. Accordingly, embodiments as set forth herein are intended to be illustrative and not limiting.
In summary, A gain cell memory device includes a semiconductor device layer of a silicon on insulator (SOI) substrate comprising an active region, a storage transistor over the active region of the semiconductor device layer, an isolation structure between a gate electrode of the storage transistor and a source/drain region adjacent to the storage transistor, the isolation structure extending through the active region such that a first portion of the active region is isolated from a second portion of the active region, and a capacitor coupled to the storage transistor. A bottom plate of the capacitor comprises the first portion of the active region, a gate dielectric layer of the storage transistor is an insulator of the capacitor, and a top plate of the capacitor comprises the gate electrode of the storage transistor and a metal structure over the gate electrode.
The following embodiments are explicitly disclosed.
Embodiment 1: A gain cell memory device, comprising:
   an active region of a semiconductor device layer of a silicon on insulator (SOI) substrate;
   a storage transistor over the active region;
   an isolation structure between a gate electrode of the storage transistor and a source/drain region adjacent to the storage transistor, the isolation structure extending through the active region such that a first portion of the active region under the storage transistor is isolated from a second portion of the active region; and
   a capacitor coupled to the storage transistor, wherein a bottom plate of the capacitor comprises the first portion of the active region, a gate dielectric layer of the storage transistor is an insulator of the capacitor, and a top plate of the capacitor comprises the gate electrode of the storage transistor and a metal structure over the gate electrode.
Embodiment 2: The gain cell memory device of embodiment 1, wherein the metal structure comprises a metal plate that extends over the isolation structure.
Embodiment 3: The gain cell memory device of embodiment 2, wherein the source/drain region is between the storage transistor and a write transistor of the gain cell memory device.
Embodiment 4: The gain cell memory device of one of embodiments 1 to 3, further comprising a second storage transistor over the first portion of the active region and a second isolation structure between a gate electrode of the second storage transistor and a second source/drain region adjacent to the second storage transistor.
Embodiment 5: The gain cell memory device of embodiment 4, wherein the second isolation structure isolates the first portion of the active region from a third portion of the active region.
Embodiment 6: The gain cell memory device of embodiment 4 or 5, further comprising a second capacitor coupled to the second storage transistor, wherein the bottom plate of the second capacitor comprises the first portion of the active region.
Embodiment 7: The gain cell memory device of one of embodiments 1 to 6, wherein the metal structure comprises a contact coupled to the gate electrode of the storage transistor.
Embodiment 8: The gain cell memory device of embodiment 7, wherein the contact is coupled to a ground line.
Embodiment 9: The gain cell memory device of one of embodiments 1 to 8, wherein the SOI substrate is a fully-depleted SOI (FDSOI) substrate.
Embodiment 10: The gain cell memory device of one of embodiments 1 to 9, wherein the gain cell memory device is an embedded dynamic random access memory (eDRAM) device.
Embodiment 11: An array of gain cell embedded dynamic random access memory (eDRAM) devices, each gain cell eDRAM device comprising:
   an active region of a semiconductor device layer of a silicon on insulator (SOI) substrate;
   a storage transistor over the active region;
   an isolation structure between a gate electrode of the storage transistor and a source/drain region adjacent to the storage transistor, the isolation structure extending through the active region such that a first portion of the active region under the storage transistor is isolated from a second portion of the active region; and
   a capacitor coupled to the storage transistor, wherein a bottom plate of the capacitor comprises the first portion of the active region, a gate dielectric layer of the storage transistor is an insulator of the capacitor, and a top plate of the capacitor comprises the gate electrode of the storage transistor and a metal structure over the gate electrode.
   In some illustrative examples of embodiment 11, the array of gain cell eDRAM devices may be formed such that each gain cell eDRAM device is formed in accordance with the gain cell memory device of one of embodiments 1 to 10.
Embodiment 12: The array of embodiment 11, wherein the metal structure comprises a metal plate that extends over the isolation structure.
Embodiment 13: The array of embodiment 11 or 12, wherein the source/drain region is between the storage transistor and a write transistor of the gain cell memory device.
Embodiment 14: The array of one of embodiments 11 to 13, wherein each gain cell eDRAM device further comprises a second storage transistor over the first portion of the active region and a second isolation structure between a gate electrode of the second storage transistor and a second source/drain region adjacent to the second storage transistor.
Embodiment 15: The array of embodiment 14, wherein the second isolation structure isolates the first portion of the active region from a third portion of the active region.
Embodiment 16: The array of embodiment 14 or 15, further comprising a second capacitor coupled to the second storage transistor, wherein the bottom plate of the second capacitor comprises the first portion of the active region.
Embodiment 17: The array of one of embodiments 11 to 16, wherein the metal structure comprises a contact coupled to the gate electrode of the storage transistor.
Embodiment 18: The array of embodiment 17, wherein the contact is coupled to a ground line.
Embodiment 19: The array of one of embodiments 11 to 18, wherein the SOI substrate is a fully-depleted SOI (FDSOI) substrate.
Embodiment 20: A method for forming a gain cell memory device, the method comprising:
   forming an active region in a semiconductor device layer of a silicon on insulator (SOI) substrate;
   forming a storage transistor over the semiconductor device layer, the storage transistor comprising a gate dielectric and a gate electrode;
   forming an isolation structure between the gate electrode of the storage transistor and a source/drain region adjacent to the storage transistor, the isolation structure extending through the active region such that a first portion of the active region under the storage transistor is isolated from a second portion of the active region; and
   forming a capacitor coupled to the storage transistor, wherein a bottom plate of the capacitor comprises the first portion of the active region, the gate dielectric layer of the storage transistor is an insulator of the capacitor, and a top plate of the capacitor comprises the gate electrode of the storage transistor and a metal structure over the gate electrode.
Embodiment 21: The method of embodiment 20, further comprising at least one further gain cell memory device, the method further comprising:
   forming at least one other active region in the semiconductor device layer of the silicon on insulator (SOI) substrate;
   forming at least one other storage transistor over the semiconductor device layer, each of the at least one other storage transistor comprising another gate dielectric and another gate electrode;
   forming at least one other isolation structure, wherein for each of the at least one further gain cell memory device the at least one other isolation structure is between the gate electrode of the at least one other storage transistor and an associated source/drain region adjacent to the at least one storage transistor, each of the at least one other isolation structure extending through the associated active region such that an associated first portion of the associated active region under the associated storage transistor is isolated from an associated second portion of the associated active region; and
   forming at least one other capacitor coupled to the at least one other storage transistor, wherein an associated bottom plate of the at least one other capacitor comprises the associated first portion of the associated active region, the associated gate dielectric layer of the associated storage transistor is an insulator of the at least one other capacitor, and an associated top plate of the capacitor comprises the gate electrode of the associated storage transistor and an associated metal structure over the gate electrode.
   Accordingly, an array of gain cell embedded dynamic random access memory (eDRAM) devices may be formed by forming a plurality of gain cell memory devices, each of which being formed in accordance with embodiment 20.
Embodiment 22: The method of embodiment 20, wherein the gain cell memory device of one of embodiments 1 to 10 is formed.
Embodiment 23: The method of embodiment 21, wherein the array of gain cell eDRAM devices of embodiment 11 is formed.

## Claims

1. A gain cell memory device, comprising:
an active region of a semiconductor device layer of a silicon on insulator (SOI) substrate;
a storage transistor over the active region;
an isolation structure between a gate electrode of the storage transistor and a source/drain region adjacent to the storage transistor, the isolation structure extending through the active region such that a first portion of the active region under the storage transistor is isolated from a second portion of the active region; and
a capacitor coupled to the storage transistor, wherein a bottom plate of the capacitor comprises the first portion of the active region, a gate dielectric layer of the storage transistor is an insulator of the capacitor, and a top plate of the capacitor comprises the gate electrode of the storage transistor and a metal structure over the gate electrode.

2. The gain cell memory device of claim 1, wherein the metal structure comprises a metal plate that extends over the isolation structure.

3. The gain cell memory device of claim 2, wherein the source/drain region is between the storage transistor and a write transistor of the gain cell memory device.

4. The gain cell memory device of one of claims 1 to 3, further comprising a second storage transistor over the first portion of the active region and a second isolation structure between a gate electrode of the second storage transistor and a second source/drain region adjacent to the second storage transistor.

5. The gain cell memory device of claim 4, wherein the second isolation structure isolates the first portion of the active region from a third portion of the active region.

6. The gain cell memory device of claim 4 or 5, further comprising a second capacitor coupled to the second storage transistor, wherein the bottom plate of the second capacitor comprises the first portion of the active region.

7. The gain cell memory device of one of claims 1 to 6, wherein the metal structure comprises a contact coupled to the gate electrode of the storage transistor.

8. The gain cell memory device of claim 7, wherein the contact is coupled to a ground line.

9. The gain cell memory device of one of claims 1 to 8, wherein the SOI substrate is a fully-depleted SOI (FDSOI) substrate.

10. The gain cell memory device of one of claims 1 to 9, wherein the gain cell memory device is an embedded dynamic random access memory (eDRAM) device.

11. An array of gain cell embedded dynamic random access memory (eDRAM) devices, wherein each gain cell eDRAM device is provided in accordance with the gain cell memory device of one of claims 1 to 10.

12. A method for forming a gain cell memory device, the method comprising:
forming an active region in a semiconductor device layer of a silicon on insulator (SOI) substrate;
forming a storage transistor over the semiconductor device layer, the storage transistor comprising a gate dielectric and a gate electrode;
forming an isolation structure between the gate electrode of the storage transistor and a source/drain region adjacent to the storage transistor, the isolation structure extending through the active region such that a first portion of the active region under the storage transistor is isolated from a second portion of the active region; and
forming a capacitor coupled to the storage transistor, wherein a bottom plate of the capacitor comprises the first portion of the active region, the gate dielectric layer of the storage transistor is an insulator of the capacitor, and a top plate of the capacitor comprises the gate electrode of the storage transistor and a metal structure over the gate electrode.

13. The method of claim 12, further comprising at least one further gain cell memory device, the method further comprising:
forming at least one other active region in the semiconductor device layer of the silicon on insulator (SOI) substrate;
forming at least one other storage transistor over the semiconductor device layer, each of the at least one other storage transistor comprising another gate dielectric and another gate electrode;
forming at least one other isolation structure, wherein for each of the at least one further gain cell memory device the at least one other isolation structure is between the gate electrode of the at least one other storage transistor and an associated source/drain region adjacent to the at least one storage transistor, each of the at least one other isolation structure extending through the associated active region such that an associated first portion of the associated active region under the associated storage transistor is isolated from an associated second portion of the associated active region; and
forming at least one other capacitor coupled to the at least one other storage transistor, wherein an associated bottom plate of the at least one other capacitor comprises the associated first portion of the associated active region, the associated gate dielectric layer of the associated storage transistor is an insulator of the at least one other capacitor, and an associated top plate of the capacitor comprises the gate electrode of the associated storage transistor and an associated metal structure over the gate electrode.

14. The method of claim 12, wherein the gain cell memory device of one of claims 1 to 10 is formed.

15. The method of claim 13, wherein the array of gain cell eDRAM devices of claim 11 is formed.
